Europäisches Patentamt

European Patent Office

Office européen des brevets

(19)

(11) Veröffentlichungsnummer: **0 065 022**
**B1**

(12) **EUROPÄISCHE PATENTSCHRIFT**

(45) Veröffentlichungstag der Patentschrift:
**27.11.85**

(21) Anmeldenummer: **81103764.7**

(22) Anmeldetag: **16.05.81**

(51) Int. Cl.⁴: **H 03 M 1/66, G 11 C 8/00**

(54) **Integrierter Spannungsteiler mit Auswahlschaltung in Isolierschicht-Feldeffekttransistor-Technik, dessen Abwandlung und seine Verwendung in einem Digital-Analog-Wandler.**

(43) Veröffentlichungstag der Anmeldung:
**24.11.82 Patentblatt 82/47**

(45) Bekanntmachung des Hinweises auf die Patenterteilung:
**27.11.85 Patentblatt 85/48**

(84) Benannte Vertragsstaaten:
**DE FR GB IT NL**

(56) Entgegenhaltungen:
**WO - A - 81/00494**
**DE - A - 2 237 336**
**GB - A - 2 029 658**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Adam, Fritz Günter Dr. rer. nat. Dipl.-Phys., Furtwänglerstrasse 10, D-7800 Freiburg i. Br. (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen integrierten Spannungsteiler aus einer an einer Referenzspannung betriebenen Reihenschaltung einer Anzahl von Widerständen, dessen Abgriffe über Schaltverbindungen mittels einer Auswahlschaltung zum Spannungsausgang durchschaltbar sind, wobei Auswahlschaltung, Widerstände und Schaltverbindungen in Isolierschicht-Feldeffekttransistor-Technik realisiert sind, vgl. den Oberbegriff des Anspruchs 1.

Ein derartiger integrierter Spannungsteiler ist aus der Offenlegungsschrift DE-A1-29 30 375, Fig. 3 und 8 bekannt. Als Schaltverbindungen werden dort Serienschaltungen von Transistoren eines einheitlichen Leitungstyps, jedoch unterschiedlichen Steuerungstyps, d.h. sowohl Anreicherungstyp- als auch Verarmungstyp-Transistoren verwendet. Die Verarmungstyp-Transistoren sind dabei an denjenigen Stellen des Halbleiterkörpers angeordnet, wo sich zwei Leitbahn-Führungen kreuzen, d.h. sie dienen als sogenannte Tunnels.

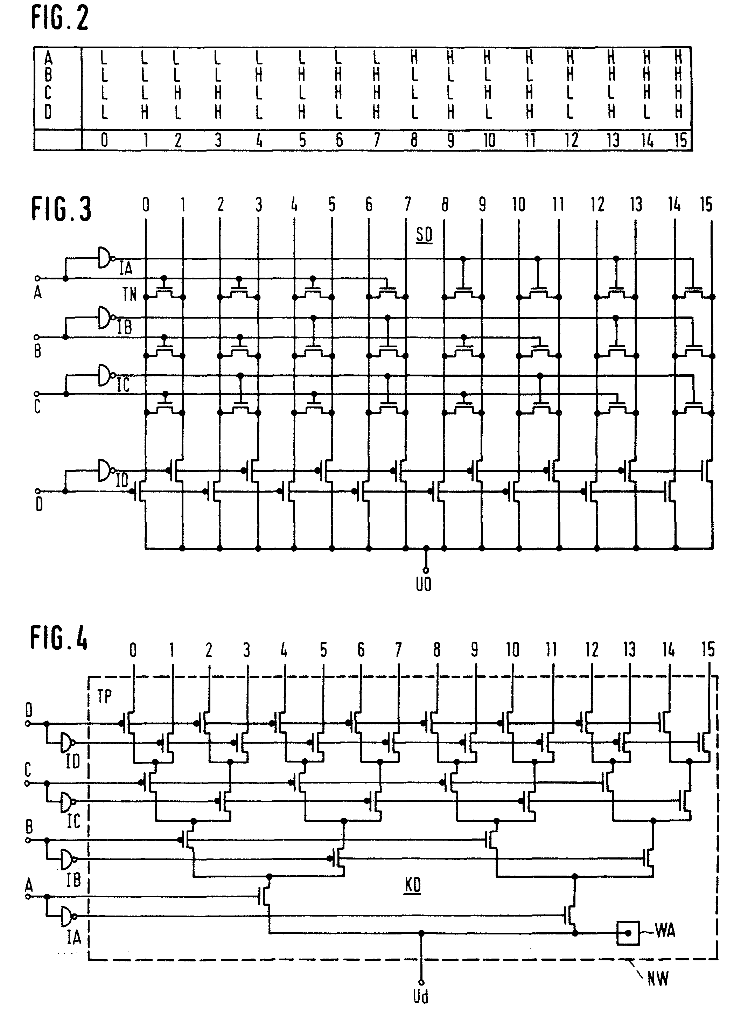

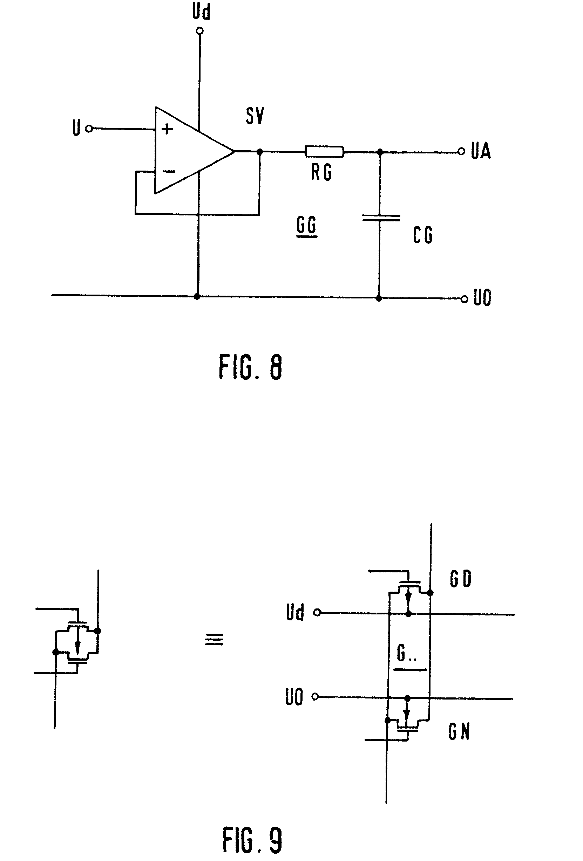

Für die in den erwähnten Fig. 3 und 8 gezeigten Ausführungsbeispiele mit acht Widerständen und einem dreistelligen Auswahlsignal liegt an den jeweiligen Spannungsteilerabgriffen die Serienschaltung aus den Schaltstrecken von bis zu acht Transistoren, so dass entweder wie bei Fig. 3 sich zu den Spannungsteilerwiderständen noch der Innenwiderstand dieser Serienschaltungen addiert oder wie bei Fig. 8 der zu berücksichtigende Serienwiderstand von Abgriff zu Abgriff grösser wird. Der vom Spannungsausgang her gesehene Innenwiderstand des Spannungsteilers setzt sich also aus den eigentlichen Spannungsteilerwiderständen und den Ersatzwiderständen der einzelnen Serienschaltungen zusammen. Der Spannungsausgang soll aber möglichst niederohmig mit den Spannungsteilerabgriffen in Verbindung stehen, was mit den bekannten Anordnungen nur schwerlich erreicht werden kann.

Hier will die Erfindung Abhilfe schaffen, die, wie sie in den Ansprüchen gekennzeichnet ist, die Aufgabe löst, einen integrierten Spannungsteiler der im Oberbegriff des Anspruchs 1 angegebenen Art so auszubilden, dass zwischen jedem Spannungsteilerabgriff und dem Spannungsausgang möglichst der gleiche Widerstandswert auftritt und dass die Auswahlschaltung mit einem möglichst geringen Ruhestrom betrieben werden kann.

Durch die vorgesehene Trennung der Durchschaltfunktion von der Auswahlfunktion, welche beiden Funktionen bei den bekannten Anordnungen in den erwähnten Serienschaltungen vereinigt sind, lässt sich die gestellte Aufgabe lösen. Dabei ergibt sich der weitere Vorteil, dass an die Genauigkeit der Widerstandswerte des Spannungsteilers weit geringere Anforderungen zu stellen sind als bei Spannungsteilern, die nach dem R-2R-Prinzip arbeiten. Diese Eigenschaft wird wesentlich dadurch gesichert, dass die Schaltverbindungen zwischen den Spannungsteilerabgriffen und dem Spannungsausgang jeweils nur durch einzelne oder – bei Verwendung von Transmission-Gates – durch parallelgeschaltete Transistorschaltstrecken realisiert werden.

Aus der DE-A- 22 37 336 ist es an sich bekannt, für die Durchschaltfunktion einen einzigen Transistor zu verwenden.

Ferner ist auch die Verwendung einer Eins-Aus-N-Auswahlschaltung vorgesehen, die sich bei dem angesprochenen Wandlertyp, bei dem die N quantisierten Spannungswerte aus N einzeln Potentialabgriffen gebildet werden, zwingend ergibt.

Aus der älteren, jedoch nicht vorveröffentlichten europäischen Patentanmeldung EP-A1-0 061 512 vgl. Seite 3, Zeilen 3 bis 12, ist es an sich bekannt, als Auswahlschaltung einen Eins-Aus-N-Kurzschlussdekoder und einen Eins-Aus-N-Sperrdekoder zusammenwirken zu lassen, wobei der Eins-Aus-N-Kurzschlussdekoder nur aus Transistoren des einen Kanalleitungstyps und der Eins-Aus-N-Sperrdekoder nur aus Transistoren des anderen Kanalleitungstyps besteht, die innerhalb einer eigenen Isolierwanne des einen Kanalleitungstyps angeordnet sind. Diese Auswahlschaltung ist in der genannten älteren europäischen Patentanmeldung zum Schreiben, Lesen und Löschen von Speichermatrizen mit Isolierschicht-Feldeffekttransistoren. Dieser Stand der Technik fällt unter Art. 54 (3) EPÜ.

Die Erfindung wird nun anhand der Figuren der Zeichnung näher erläutert.

Fig. 1 zeigt teilweise schematisch das Schaltbild eines Ausführungsbeispiels der Erfindung für acht Abgriffe und ein dreistelliges Auswahlsignal,

Fig. 2 zeigt tabellarisch die Zuordnung der 16 Zustände eines vierstelligen natürlich-binärcodierten Auswahlsignals,

Fig. 3 zeigt das Schaltbild eines bei der Erfindung verwendbaren Sperrdecoders, der mit einem Auswahlsignal nach Fig. 2 angesteuert wird,

Fig. 4 zeigt das Schaltbild eines bei der Erfindung verwendbaren Kurzschlussdecoders für ein Auswahlsignal nach Fig. 2,

Fig. 5 zeigt eine Abwandlung der Anordnung nach Fig. 1 für den Betrieb mit höheren Referenzspannungen,

Fig. 6 zeigt eine Weiterbildung der Anordnung nach Fig. 5,

Fig. 7 zeigt eine Weiterbildung der Anordnung nach Fig. 6,

Fig. 8 zeigt die Beschaltung des Spannungsausgangs mit einem Verstärker in Spannungsfolgerschaltung und einem Glättungsglied bei Verwendung der Erfindung als Digital-Analog-Wandler, und

Fig. 9 zeigt die Beschaltung des Substrats der Transmission-Gates nach Fig. 5.

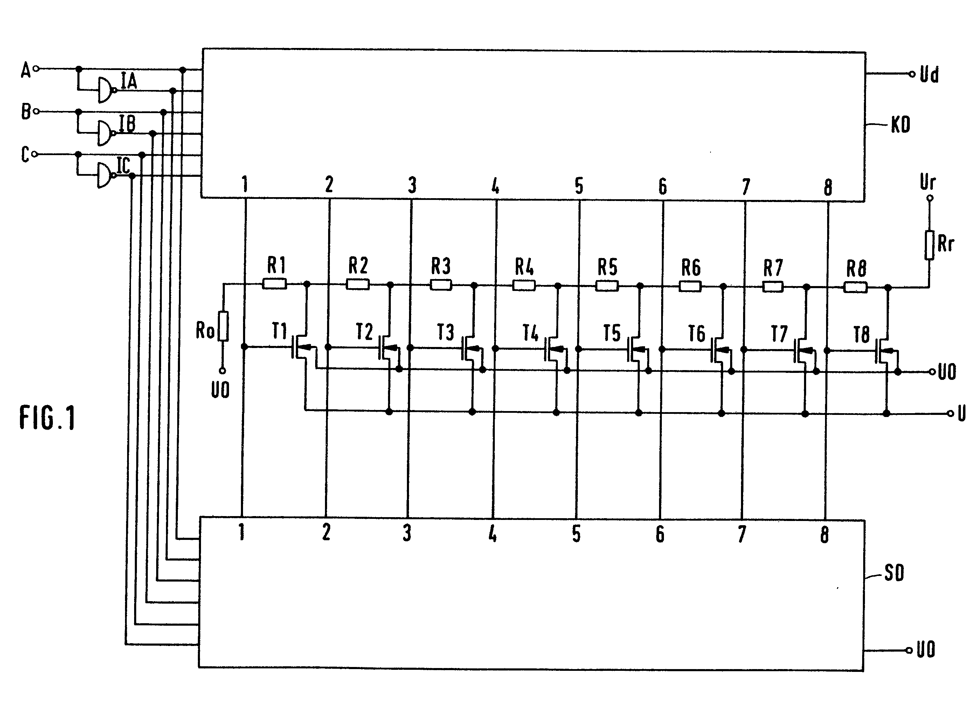

In Fig. 1 ist teilweise schematisch das Schaltbild eines Ausführungsbeispiels der Erfindung für einen mit acht Abgriffen versehenen Spannungsteiler gezeigt, der aus den Widerständen R0, R1...R8, Rr besteht, die in dieser Reihenfolge zwischen dem Bezugspotential UO der Referenzspannungsquelle Ur und deren spannungsführenden Pol angeordnet sind. Der Widerstand R0 kann wahlweise auch entfallen. Die Verbindungspunkte jeweils benachbarter Widerstände R1...R8, die die acht Abgriffe bilden, sind jeweils über die Schaltstrecke der Schalttransistoren T1...T8 mit dem Spannungsausgang U verbunden. Jeder Abgriff liegt über einen einzigen derartigen Schalttransistor am Spannungsausgang U. Die Schalttransistoren sind alle vom selben Kanalleitungstyp, in Fig. 1 sind es N-Kanal-Transistoren, deren Substrat am Bezugspotential UO der Referenzspannungsquelle Ur liegt. Der Potentialbereich von UO bis zum Potential am höchsten Abgriff zwischen den Widerständen R8 und Rr kann sich bei diesem Ausführungsbeispiel nur über einen Teil des Referenzspannungsbereichs erstrecken. Soll das Potential am höchsten Abgriff mit Ur übereinstimmen so muss der Widerstand Rr entfallen.

Zur Ansteuerung der Gates der Schalttransistoren und damit zur Durchschaltung des entsprechenden Abgriffpotentials an den Spannungsausgang U dient die aus dem Eins-Aus-N-Kurzschlussdecoder KD und aus dem Eins-Aus-N-Sperrdecoder SD bestehende Auswahlschaltung, wobei gleichnamige Eingänge der beiden Decoder parallelgeschaltet und mit den entsprechenden Stellen A, B, C des Auswahlsignals gespeist sind. Ebenso sind die gleichnahmigen Ausgänge 1...8 der beiden Decoder KD, SD miteinander verbunden und steuern jeweils das Gate des zugehörigen Transistors mit derselben Bezugszeichenziffer; die Ausgänge 1 liegen also z.B. am Gate des Transistors T1.

Die gewöhnlich erforderliche Speisung der Eingänge der beiden Decoder KD, SD sowohl mit den direkten als auch mit den invertierten Stellensignalen des Auswahlsignals A, B, C ist in Fig. 1 durch die Vorinverter IA, IB, IC angedeutet. Der Sperrdecoder SD besteht ausschliesslich aus Transistoren des einen Kanalleitungstyps, in Fig. 1 also aus N-Kanal-Transistoren, die in dem mit dem Bezugspotential UO der Referenzspannungsquelle Ur verbundenen Halbleiterkörper des integrierten Spannungsteilers angeordnet sind, wobei der Potentialeingang des Sperrdecoders SD ebenfalls mit diesem Bezugspotential UO verbunden ist.

Im Gegensatz dazu besteht der Kurzschlussdecoder KD ausschliesslich aus Transistoren des anderen Kanalleitungstyps, in Fig. 1 also aus P-Kanal-Transistoren, die innerhalb einer eigenen Isolierwanne (NW in Fig. 4) des einen Kanalleitungstyps angeordnet sind, und sein Potentialeingang ist mit dieser Isolierwanne und mit der Betriebsspannung Ud verbunden. Durch die parallele Ansteuerung auf der Adressenseite und die Parallelschaltung der Ausgänge 1...8 der beiden Decoder ergibt sich insgesamt eine CMOS-Inverter-artige Zusammenschaltung, die genau deren Eigenschaften bezüglich des Ruhestromverbrauchs aufweist.

Die Tabelle der Fig. 2 zeigt die Zustände eines vierstelligen, natürlich-binärcodierten Auswahlsignals A...D, wie es zur Ansteuerung der in den Fig. 3 und 4 gezeigten Decoder verwendet werden kann.

So zeigt die Fig. 3 das Schaltbild eines mit diesem vierstelligen Auswahlsignal A...D ansteuerbaren Sperrdecoder SD, der ausschliesslich aus N-Kanal-Transistoren TN aufgebaut ist. Das funktionsmässig Charakteristische dieses Sperrdecoders ist, dass alle vom Bezugspotential UO zum adressierten Ausgang möglichen Verbindungsleitungen unterbrochen bzw. gesperrt sind, während zu den nichtadressierten Ausgängen jeweils mindestens eine Verbindungsleitung durchgeschaltet ist. Der schaltungstechnische Aufbau des Sperrdecoders SD nach Fig. 3 lässt sich so beschreiben, dass der niederstwertigen Stelle D des Auswahlsignals je einer der zu den 16 Ausgängen gehörenden Längstransistoren zugeordnet ist, die zwischen dem Bezugspotential UO und dem entsprechenden Ausgang liegen. Diese Längsttransistoren sind abwechselnd jeweils vom Auswahl-Stellensignal D direkt oder über den Vorinverter ID angesteuert. Die beiden Ausgänge eines derartigen Längstransistoren-Paares sind dann über drei jeweils den restlichen drei Stellen zugeordnete Quertransistoren miteinander verbunden, die entsprechend der Fig. 3 direkt oder über den entsprechenden Vorinverter vom entsprechenden Auswahl-Stellensignal A, B, C angesteuert sind.

Die Fig. 4 zeigt das Schaltbild des entsprechenden Kurzschlussdecoder KD, der ausschliesslich mit P-Kanal-Transistoren TP realisiert ist. Alle P-Kanal-Transistoren TP sind in der N-leitenden Isolierwanne NW des Halbleiterkörpers angeordnet, die ihrerseits über den Kontakt WA mit der Betriebsspannung Ud verbunden ist. Das funktionsmässig Charakteristische des Kurzschlussdecoders KD ist, dass alle Verbindungsleitungen zwischen der Betriebsspannung Ud und den nichtadressierten Decoderausgängen mindestens durch einen gesperrten Transistor unterbrochen sind, während die Verbindungsleitung zwischen der adressierten Ausgangsleitung und der Betriebsspannung Ud mittels der in Serie liegenden Transistoren durchgeschaltet ist. Der schaltungsgemässe Aufbau kann etwa so beschrieben werden, dass, ausgehend von dem dem höchstwertigen Stellensignal A zugeordneten und sourceseitig mit der Betriebsspannung Ud verbundenen Transistorpaar der Aufbau sich baum-artig zu den Stellensignalen niedriger Wertigkeit hin jeweils in zwei Äste verzweigt. Dabei sind die beiden Transistoren, die jeweils sourceseitig zusammengeschaltet sind, vom entsprechenden Stellensignal direkt bzw. über den Vorinverter angesteuert.

Durch die ausgangsseitige Parallelschaltung der beiden Decoder nach den Fig. 3 und 4 ergibt sich somit für jede einer Adresse zugeordnete Verbindungleitung zwischen Bezugspotential UO und Betriebsspannung Ud das einem einfachen CMOS-Inverter entsprechende Verhalten, und zwar derart, dass der jeweils adressierte Ausgang das Potential des Kurzschlussdecodersubstrats annimmt, während alle nichtadressierten Ausgänge das Potential des Sperrdecodersubstrats annehmen.

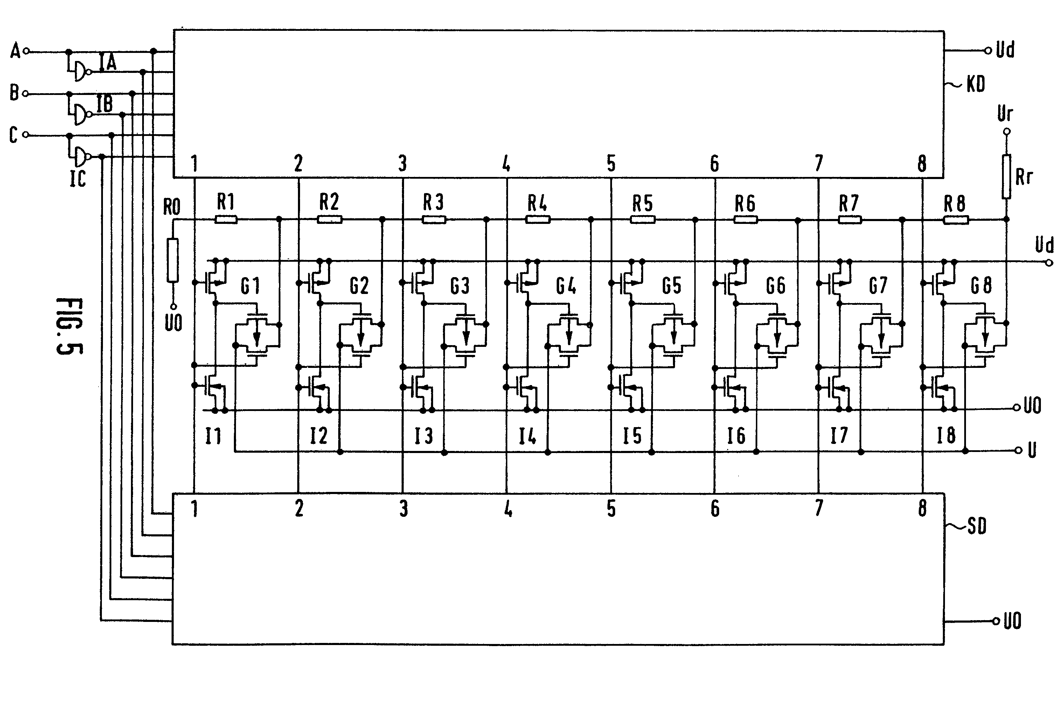

Wenn der integrierte Spannungsteiler nach der Erfindung vollständig in CMOS-Technik realisiert werden soll, so können die Schalttransistoren T.. nach Fig. 1 durch CMOS-Transmission-Gates mit zugeordneten CMOS-Invertern ersetzt werden. Die Fig. 5 zeigt ein entsprechendes Ausführungsbeispiel für das dreistellige Auswahlsignal wie in Fig. 1. Anstatt der dort gezeigten Schalttransistoren T1...T8 sind die Transmission-Gates G1...G8 vorgesehen, deren Schaltstrecke zwischen dem jeweils zugehörigen Spannungsteilerabgriff und dem Spannungsausgang U liegt. Die einen Steuereingänge der Transmission-Gates G1...G8 sind mit den zugeordneten parallelgeschalteten Ausgängen der beiden Decoder SD, KD direkt verbunden, während die anderen Steuereingänge über die entsprechenden CMOS-Inverter I1...I8 an diesen Ausgängen angeschlossen sind. Bei der für das Ausführungsbeispiel der Fig. 5 gewählten Polarität für die Schalttransistoren der beiden Decoder SD, KD, die gleich ist wie beim Ausführungsbeispiel der Fig. 1 und den Fig. 3 und 4 (Sperrdecoder SD mit N-Kanal-Transistoren TN, Kurzschlussdecoder KD mit P-Kanal-Transistoren TP), ist das Gate der N-Kanal-Transistoren der Transmission-Gates direkt und das Gate der P-Kanal-Transistoren über die CMOS-Inverter angesteuert.

Die Fig. 9 zeigt, an welches Potential das Substrat der Transmission-Gate-Transistoren anzuschliessen ist, das Substrat des P-Kanal-Transistors GP an die Betriebsspannung Ud und das des N-Kanal-Transistors GN an das Bezugspotential UO der Referenzspannungsquelle Ur. In gleicher Weise ist im übrigen auch das jeweilige Substrat der CMOS-Inverter-Transistoren mit der Betriebsspannung Ud bzw. der Referenzspannung UO verbunden, zwischen welchen beiden Potentialen auch die Schaltstrecke der CMOS-Inverter liegt.

Durch die vollständige Ausführung des integrierten Spannungsteilers in CMOS-Technik entsprechend Fig. 5 ergibt sich die Möglichkeit und somit der Vorteil, mit einer grösseren Referenzspannung Ur≤Ud arbeiten zu können, so dass sich entlang des Spannungsteilers grössere Potentialstufen ergeben, die die halbleitertechnische Realisierung des Spannungsteilers hinsichtlich der Toleranzbedingungen erleichtern. Insbesondere kann als Referenzspannung Ur jetzt auch die volle Betriebsspannung Ud gewählt werden und der Widerstand Rr kann dann entfallen.

Für ein vollständiges und schnelles Durchschalten der Teilspannungen an den Spannungsteilerabgriffen sollte die Betriebsspannung Ud mindestens gleich der Summe aus den Beträgen der Schwellenspannung der P-Kanal-Transistoren, der Schwellenspannung der N-Kanal-Transistoren und der effektiven Gate-Source-Spannung der Transistoren sein.

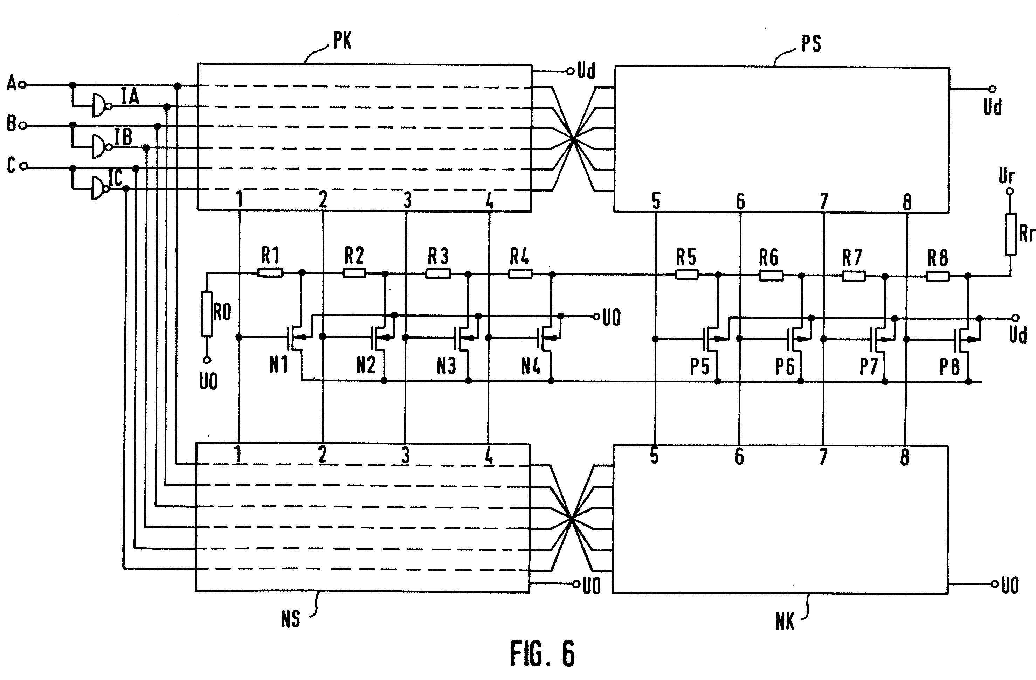

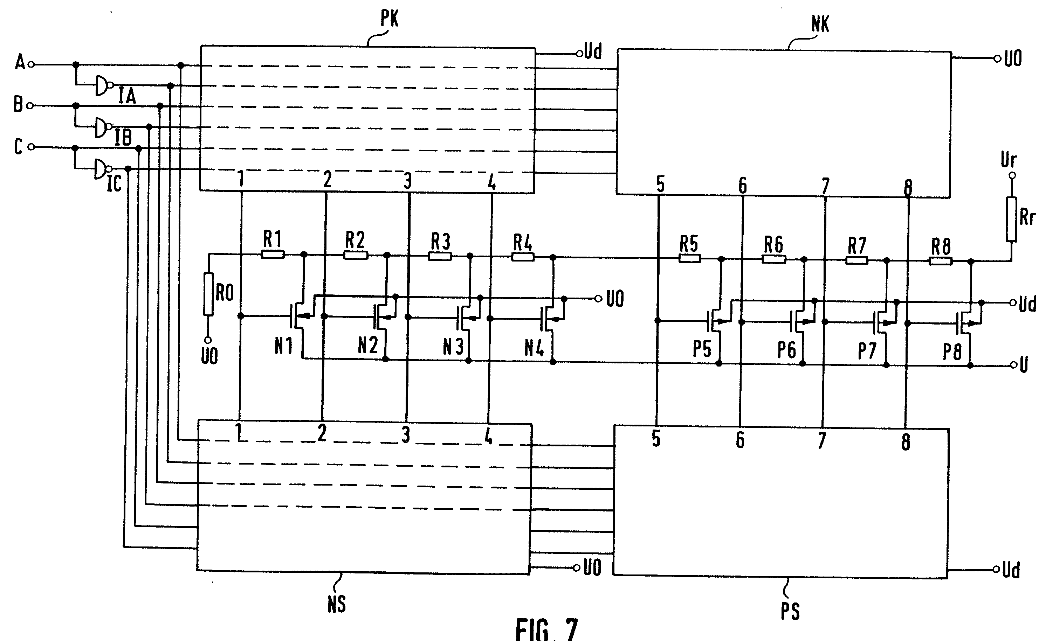

Gegenüber Ausführungsformen entsprechend Fig. 1 weist die abgewandelte Ausführungsform nach Fig. 5 einen praktisch dreifachen Aufwand an Transistoren auf. Sollte dieser Aufwand, insbesondere bei Spannungsteilern mit einer grösseren Anzahl von Abgriffen, nicht mehr akzeptabel sein, so kann unter Beibehaltung des vollständigen CMOS-Prinzips dieser Aufwand reduziert werden, wie es in den Fig. 6 und 7 gezeigt ist. Für das schnelle und vollständige Durchschalten der Abgriffspannungen ist es nämlich ausreichend, wenn die bezüglich des Mittelabgriffs negativen Teilspannungen mittels N-Kanal-Schalttransistoren und die bezüglich des Mittelabgriffs positiven Teilspannungen mittels P-Kanal-Schalttransistoren zum Spannungsausgang U durchgeschaltet werden. Dabei ist für das Ausführungsbeispiel nach Fig. 6 vorausgesetzt, dass die Betriebsspannung Ud und die Referenzspannung Ur positive Spannungen sind. In Fig. 6 sind somit die vier N-Kanal-Schalttransistoren N1...N4 vorhanden, deren Substrat am Bezugspotential UO liegt und die die Teilspannungen an den zu den Widerständen R1...R4 gehörenden Abgriffen sind die P-Kanal-Schalttransistoren P5...P8 zugeordnet, deren Substrat mit der Betriebsspannung Ud verbunden ist.

In Fig. 6 müssen gegenüber den Ausführungsbeispielen nach den Fig. 1 und 5 noch die folgenden Modifikationen vorgenommen werden. Der den positiven Teilspannungen zugeordnete Teil des Sperrdecoders ist durch den N-Kanal-Kurzschluss-Teildecoder NK ersetzt, dessen Potentialeingang mit dem Bezugspotential UO verbunden ist und dessen Transistoren im Halbleiterkörper des integrierten Spannungsteilers angeordnet sind. Der den positiven Teilspannungen zugeordnete Teil des Kurzschlussdecoders ist durch den P-Kanal-Sperr-Teildecoder PS ersetzt, dessen Potentialeingang an der Betriebsspannung Ud liegt und dessen Transistoren in einer einzigen, mit der Betriebsspannung Ud verbundenen Isolierwanne angeordnet sind.

Die Eingänge der Teildecoder NK, PS sind in umgekehrter Reihenfolge mit den entsprechenden Eingängen des verbleibenden N-Kanal-Sperr-Teildecoders NS bzw. des verbleibenden P-Kanal-Kurzschluss-Teildecoders PK verbunden. Der Potentialeingang des N-Kanal-Sperrdecoders NS liegt am Bezugspotential UO, und seine Transistoren sind im Halbleiterkörper angeordnet, während der Potentialeingang des P-Kanal-Kurzschluss-Teildecoders PK an der Betriebsspannung Ud liegt und seine Transistoren in einer eignen Isolierwanne des Halbleiterkörpers angeordnet sind. Aus Übersichtlichkeitsgründen der zeichnerischen Darstellung ist in Fig. 6 (ebenso in Fig. 7) die Eingangsleitungsführung in den Schaltsymbolen der Teildecoder NS, PK von links nach rechts gestrichelt weitergeführt. Durch die Aufteilung in die erwähnten Teildecoder wird erreicht, dass das zur Ansteuerung der P-Kanal-Schalttransistoren P5...P8 erforderliche Ausgangssignal erhalten wird.

Da die sich überkreuzenden Leitungsführungen beim Ausführungsbeispiel nach Fig. 6 ebenfalls einen zusätzlichen Flächenaufwand in der integrierten Schaltung verursachen, kann entsprechend Fig. 7 durch eine andere Zuordnung wieder zu nicht sich überkreuzende Leitungsführungen zurückgekehrt werden. Dies ist dadurch möglich, dass im Vergleich zu Fig. 6 die Plätze der Teildecoder NK, PS vertauscht sind, so dass oberhalb des Spannungsteilers Kurzschluss-Teildecoder und unterhalb Sperr-Teildecoder angeordnet sind, allerdings jeweils mit Transistoren entgegengesetzten Kanalleitungstyps realisiert. Oberhalb des Spannungsteilers sind somit der P-Kanal-Kurzschluss-Teildecoder PK und der N-Kanal-Kurzschluss-Teildecoder NK und unterhalb der N-Kanal-Sperr-Teildecoder NS und der P-Kanal-Sperr-Teildecoder PS angeordnet. Die den positiven Teilspannungen zugeordneten Teildecoder NK, PS des Sperr- bzw. des Kurzschlussdecoders bestehen somit jeweils aus Transistoren desjenigen Kanalleitungstyps, der zum Kanalleitungstyp der den negativen Teilspannungen zugeordneten Teildecoder NS, PK entgegengesetzt ist.

Während vor dem Platztausch zu beiden Seiten des Spannungsteilers jeweils Decoder gleichen Kanalleitungstyps angeordnet sind, wobei die Teildecoder einer Seite in einer gemeinsamen, durchgehenden Isolierwanne untergebracht werden können, liegen nach dem Platztausch auf jeder Seite der Widerstandskette jeweils zwei Teildecoder verschiedenen Kanalleitungstyps, wobei sich solche mit gleichen Kanalleitungstypen diagonal gegenüberliegen.

Durch diese Massnahme lässt sich die erwähnte, durch die Leitungskreuzungen nach Fig. 6 erforderliche Zusatzfläche auf eine kleine Rest-Zusatzfläche reduzieren, und zwar auf so viel Fläche, wie für eine Isolierwannen-Grenzzone zwischen je zwei Teildecodern benötigt wird.

Die erfindungsgemässen integrierten Spannungsteiler können bevorzugt für Digital-Analog-Wandler verwendet werden. Soll die Wandlerkennlinie dabei linear sein, so sind die Widerstände des Spannungsteilers mit gleichen Widerstandswerten auszurüsten, bei nichtlinearen Wandlungskennlinien entsprechend mit anderen Widerstandswerten. Wenn der Digital-Analog-Wandler aus einem natürlich-binärcodierten Binärsignal eine entsprechende Spannung erzeugen soll, so hat der Spannungsteiler zweckmässigerweise mindestens $N=2^n$ gleichbemessene Widerstände. Ferner ist der Spannungsausgang U mit dem Eingang eines Spannungsverstärkers zu verbinden und diesem ein RC-Glättungsglied nachzuschalten.

Für den Fall eines Digital-Analog-Wandlers unter Verwendung einer Anordnung entsprechend den Ausführungsbeispielen nach den Fig. 5 bis 7 kann ein Spannungsverstärker mit der Verstärkung 1, also ein sogenannter Spannungsfolger, verwendet werden. Diese zusätzliche Beschaltung des Spannungsausgangs U des integrierten Spannungsteilers nach der Erfindung ist in Fig. 8 schematisch gezeigt, die den Spannungsverstärker SV, der dort als Operationsverstärker in Spannungsfolgerschaltung gezeigt ist, und das aus dem Widerstand RG und dem Kondensator CG bestehende Glättungsglied GG zeigt, an dessen Ausgang die analoge Ausgangsspannung UA abgegriffen werden kann.

**Patentansprüche**

1. Intergrierter Spannungsteiler aus einer an einer Referenzspannung (Ur) betriebenen Reihenschaltung einer Anzahl (N) von Widerständen (R0, R1...R8, Rr), dessen Abgriffe jeweils über eine Schaltverbindung, die aus einem einzelnen Schalttransistor oder einer Serienschaltung von Schalttransistoren besteht, in Abhängigkeit von einem digitalen Auswahlsignal (A...D) zum Spannungsausgang (U) mittels einer Auswahlschaltung durchschaltbar sind, wobei Auswahlschaltung, Widerstände (R. .) und Schaltverbindungen unter Verwendung von Transistoren in Isolierschicht-Feldeffekttransistor-Technik realisiert sind, gekennzeichnet durch die Kombination folgender Merkmale:
   - jede Schaltverbindung ist durch die Schaltstrecke eines einzigen Schalttransistors (T1...T8) vom einen Kanalleitungstyp (N-Kanal in den Figuren) realisiert,
   - die Auswahlschaltung besteht aus einem Eins-Aus-N-Kurzschlussdecoder (KD) und aus einem Eins-Aus-N-Sperrdecoder (SD), deren gleichnamige Eingänge parallelgeschaltet und mit den entsprechenden Stellen (A...D) des Auswahlsignals gespeist sind,
   - der Sperrdecoder (SD) besteht nur aus Transistoren des einen Kanalleitungstyps, die in dem mit dem Bezugspotential (UO) der Referenzspannung (Ur) verbundenen Halbleiterkörper angeordnet sind, und sien Potentialeingang ist mit dem Bezugspotential (UO) verbunden,
   - der Kurzschlussdecoder (KD) besteht nur aus Transistoren des anderen Kanalleitungstyps (P-Kanal in den Figuren), die innerhalb einer eigenen Isolierwanne (NW) des einen Kanalleitungstyps angeordnet sind, und sein Potentialeingang ist mit dieser Isolierwanne (NW) und mit der Betriebsspannung (Ud) verbunden, und
   - gleichnamige Ausgänge (1...8) von Sperr- und Kurzschlussdecoder (SD, KD) sind miteinander und mit dem jeweiligen Gate der Schalttransistoren (T. .) verbunden.

2. Integrierter Spannungsteiler aus einer an einer Referenzspannung (Ur) betriebenen Reihenschaltung einer Anzahl (N) von Widerständen (R0, R1...R8, Rr), dessen Abgriffe jeweils über eine Schaltverbindung, die aus einem einzelnen Schalttransistor oder einer Serienschaltung von Schalttransistoren besteht, in Abhängigkeit von einem digitalen Auswahlsignal (A...D) zum Spannungsausgang (U) mittels einer Auswahlschaltung durchschaltbar sind, wobei Auswahlschaltung, Widerstände (R. .) und Schaltverbindungen unter Verwendung von Transistoren in Isolierschicht-Feldeffekttransistor-Technik realisiert sind, gekennzeichnet durch die Kombination folgender Merkmale:
   - jede Schaltverbindung ist als CMOS-Transmission-Gate (G1...G8) realisiert,

– die Auswahlschaltung besteht aus einem Eins-Aus-N-Kurzschlussdecoder (KD) und aus einem Eins-Aus-N-Sperrdecoder (SD), deren gleichnamige Eingänge parallelgeschaltet und mit den entsprechenden Stellen (A...D) des Auswahlsignals gespeist sind,

– der Sperrdecoder (SD) besteht nur aus Transistoren des einen Kanalleitungstyps, die in dem mit dem Bezugspotential (UO) der Referenzspannung (Ur) verbundenen Halbleiterkörper angeordnet sind, und sein Potentialeingang ist mit dem Bezugspotential (UO) verbunden,

– der Kurzschlussdecoder (KD) besteht nur aus Transistoren des anderen Kanalleitungstyps (P-Kanal in den Figuren), die innerhalb einer eigenen Isolierwanne (NW) des einen Kanalleitungstyps angeordnet sind, und sein Potentialeingang ist mit dieser Isolierwanne (NW) und mit der Betriebsspannung (Ud) verbunden, und

– die einen Steuereingänge der CMOS-Transmission-Gates (G1...G8) sind direkt mit den gleichnamigen Ausgängen (1...8) von Sperr- und Kurzschlussdecoder (SD, KD) und deren andere Steuereingänge jeweils über einen CMOS-Inverter (I1...I8) mit den gleichnamigen Ausgängen (1...8) verbunden (Fig. 5).

3. Spannungsteiler nach Anspruch 1 oder 2, dadurch gekennzeichnet, dass der Sperrdecoder (SD) nur aus N-Kanal-Transistoren und der Kurzschlussdecoder (KD) nur aus P-Kanal-Transistoren aufgebaut ist.

4. Spannungsteiler nach einem der Ansprüche 1 bis 3, gekennzeichnet durch folgende Merkmale:

– die bezüglich des Mittelabgriffs zu negativen Teilspannungen gehörenden Schalttransistoren sind N-Kanal-Transistoren (N1...N4) und die bezüglich des Mittelabgriffs zu positiven Teilspannungen gehörenden Schalttransistoren sind P-Kanal-Transistoren (P5...P8), und

– der den positiven Teilspannungen zugeordnete Teil des Sperrdecoders ist als N-Kanal-Kurzschluss-Teildecoder (NK) und der den positiven Teilspannungen zugeordnete Teil des Kurzschlussdecoders als P-Kanal-Sperr-Teildecoder (PS) ausgeführt, deren jeweilige Eingänge in umgekehrter Reihenfolge mit den entsprechenden Eingängen des verbleibenden N-Kanal-Sperr-Teildecoders (NS) bzw. des verbleibenden P-Kanal-Kurzschluss-Teildecoders (PK) verbunden sind (Fig. 6).

5. Spannungsteiler nach einem der Ansprüche 1 bis 3, gekennzeichnet durch folgende Merkmale:

– die bezüglich des Mittelabgriffs zu negativen Teilspannungen gehörenden Schalttransistoren sind N-Kanal-Transistoren (N1...N4) und die bezüglich des Mittelabgriffs zu positiven Teilspannungen gehörenden Schalttransistoren sind P-Kanal-Transistoren (P5...P8),

– der den positiven Teilspannungen zugeordnete Teildecoder des Sperrdecoders besteht aus P-Kanal-Transistoren, der den negativen Teilspannungen zugeordnete Teildecoder des Sperrdecoders besteht aus N-Kanal-Transistoren, und

– beim Kurzschlussdecoder sind die Kanalleitungstypen der Teildecoder in Bezug auf die Teilspannungen genau umgekehrt zugeordnet wie beim Sperrdecoder.

6. Verwendung eines Spannungsteilers nach einem der Ansprüche 1 bis 5, in einem Digital-Analog-Wandler, derart, dass

– das Auswahlsignal ein natürliches n-stelliges Binärsignal ist,

– der Spannungsteiler mindestens $N = 2^n$ gleichbemessene Widerstände hat und

– der Spannungsausgang (U) am Eingang eines Spannungsverstärkers (SV), insbesondere mit der Verstärkung 1, liegt, dessen Ausgang mit einem RC-Glättungsglied (GG) beschaltet ist.

**Revendications**

1. Diviseur de tension intégré constitué du montage en série d'un certain nombre (N) de résistances (RO, R1...R8, Rr) alimentées par une tension de référence (Ur), dont les points de prélèvement peuvent être commutés vers la sortie de tension (U) par une liaison commutée se composant d'un transistor unique de commutation ou d'un montage en série de transistors de commutation, en fonction d'un signal numérique de sélection (A...D) à l'aide d'un circuit de sélection, le circuit de sélection, les résistances (R...) et les liaisons commutées étant réalisées par une technique de transistors à effet de champ à grille isolée, caractérisé en ce que:

– chaque liaison commutée est réalisé par la voie de commutation d'un unique transistor de commande (T1...T8) à canal d'un premier type de conductibilité (canal N sur les figures),

– le circuit de sélection se compose d'un décodeur 1 parmi N à court-circuit (KD) et d'un décodeur 1 parmi N à circuit ouvert (SD) dont les entrées de même nom sont montées en parallèle et alimentées par les chiffres correspondants (A...D) du signal de sélection,

– le décoder à circuit ouvert (SD) n'est constitué que de transistors à canal du premier type de conductibilité disposés dans le semiconducteur relié au potentiel de référence (UO) de la source de tension de référence (Ur) et que son entrée de potentiel est reliée au potentiel de référence (UO),

– le décodeur à court-circuit (KD) n'est constitué que de transistors à canal de l'autre type de conductibilité (canal P sur les figures) qui sont disposés à l'intérieur de leur cuvette d'isolation (NW) du premier type de conductibilité et en ce que son entrée de potentiel est reliée à cette cuvette d'isolation (NW) et à la tension de service (Ud), et

– les entrées de même nom (1...8) des décodeurs à circuit ouvert et à court-circuit (SD, KD) sont reliées entre elles et avec les différentes grilles des transistors de commutation (T...).

2. Diviseur de tension intégré constitué du montage en série d'un certain nombre (N) de résistances (RO, R1...R8, Rr) alimentées par une tension de référence (Ur), dont les points de prélèvement peuvent être commutés vers la sortie de tension (U) par une liaison commutée se composant d'un transistor unique de commutation ou d'un montage en série de transistors de commutation, en fonction d'un signal numérique de sélection (A...D) à l'aide d'un circuit de sélection, le circuit de sélection, les résistances (R...) et les liaisons commutées étant réalisées par une technique de transistors à effet de champ à grille isolée, caractérisé en ce que:

— chaque liaison commutée est réalisée sous la forme d'une porte de transmission CMOS (G1...G8),

— le circuit de sélection se compose d'un décodeur 1 parmi N à court-circuit (KD) et d'un décodeur 1 parmi N à circuit ouvert (SD) dont les entrées de même nom sont montées en parallèle et alimentées par les chiffres correspondants (A...D) du signal de sélection,

— le décodeur à circuit ouvert (SD) n'est constitué que de transistors à canal d'un premier type de conductibilité disposés dans le semiconducteur relié au potentiel de référence (UO) de la source de tension de référence (Ur) et en ce que son entrée de potentiel est reliée au potentiel de référence (UO),

— le décodeur à court-circuit (KD) n'est constitué que de transistors de l'autre type de conductibilité (canal P sur les figures) qui sont disposés à l'intérieur de leur cuvette d'isolation (NW) du premier type de conductibilité et en ce que son entrée de potentiel est reliée à cette cuvette d'isolation (NW) et à la tension de service (Ud), et

— les premières entrées de commande des portes de transmission CMOS (G1...G8) sont reliées directement aux sorties de même nom (1...8) des décodeurs à circuit ouvert et à (SD, KD) et que les autres entrées de commande sont reliées par l'intermédiaire d'un inverseur CMOS (I1...I8) aux sorties de même nom (1...8) (figure 5).

3. Diviseur de tension selon la revendication 1 ou 2, caractérisé en ce que le décodeur à circuit ouvert (SD) n'est constitué que de transistors à canal N et le décodeur à court-circuit (KD) que de transistors à canal P.

4. Diviseur de tension selon l'une des revendications 1 à 3, caractérisé en ce que:

— les transistors de commutation associés aux tensions partielles négatives par rapport au point de prélèvement central sont des transistors à canal N (N1...N4) et en ce que les transistors de commutation associés aux tensions partielles positives par rapport au point de prélèvement central sont des transistors à canal P (P5...P8), et

— la partie du décodeur à circuit ouvert associée aux tensions partielles positives a la forme d'un décodeur partiel à court-circuit à canal N (NK) et en ce que la partie du décodeur à court-circuit associée aux tensions partielles positives a la forme d'un décodeur partiel à circuit ouvert à canal P (PS), dont les différentes entrées sont reliées dans l'ordre inverse aux entrées correspondantes de l'autre décodeur partiel à circuit ouvert à canal N (NS) ou de l'autre décodeur partiel à court-circuit à canal P (PK) (figure 6).

5. Diviseur de tension selon l'une des revendications 1 à 3, caractérisé en ce que:

— les transistors de commutation associés aux tensions partielles négatives par rapport au point de prélèvement central sont des transistors à canal N (N1...N4) et en ce que les transistors de commutation associés aux tensions partielles positives par rapport au point de prélèvement central sont des transistors à canal P (P5...P8),

— la partie du décodeur à circuit ouvert associée aux tensions partielles positives est constituée de transistors à canal P et en ce que la partie du décodeur à court-circuit associée aux tensions partielles négatives est constituée de transistors à canal N, et

— dans le décodeur à court-circuit, les types de conductibilité des décodeurs partiels pour les tensions partielles sont exactement inversées par rapport au décodeur à circuit ouvert.

6. Convertisseur numérique analogique utilisant un diviseur de tension selon l'une des revendications 1 à 5, caractérisé en ce que:

— le signal de sélection est un signal binaire naturel à N chiffres,

— le diviseur de tension possède au moins N = $2^n$ résistances de même valeur, et

— la sortie de tension (U) est reliée à l'entrée d'un amplificateur de tension (SV), notamment d'amplification 1, dont la sortie est injectée à un élément RC de lissage (GG).

**Claims**

1. Integrated voltage divider consisting of a series arrangement of a number (N) of resistors (R0, R1...R8, Rr), operated from a biasing voltage (Ur), with the tapping points thereof, each via a switching connection consisting of one individual switching transistor or a series arrangement of switching transistors, and in dependence upon a digital selecting signal (A...D), capable of being connected through to the voltage output (U) by means of a selection circuit, with said selection circuit, said resistors (R...) and said switching connections being materialized by employing transistors according to the insulated-gate field-effect transistor technique, characterized by the combination of the following features:

— each switching connection is realized by the switching section of one single switching transistor (T1...T8) of the one channel conductivity type (n-channel in the drawings),

— the selection circuit consists of a 1-ex-n-short-circuit decoder (KD) and of a 1-ex-n-open circuit decoder (SD) whose like inputs are arranged in parallel and supplied with the corresponding bits (A...D) of the selecting signal,

— the open-circuit decoder (SD) consists only of transistors of the one channel conductivity type which are arranged in the semiconductor body of the integrated voltage divider as connected to the reference potential (UO) of the source of biasing voltage (Ur), ans its potential input is connected to the reference potential (UO),

— the short-circuit decoder (KD) consists only of transistors of the other channel conductivity type (p-channel in the drawings), which are arranged within a separate insulating island (NW) of the one channel conductivity type, and its potential input is connected to this insulating island (NW) ans to the operating voltage (Ud), and

– like outputs (1...8) of both the open-circuit and the short-circuit decoders (SD, KD) are connected to one another and to the respective gate of the switching transistors (T...).

2. An integrated voltage divider consisting of a series arrangement of a number (N) of resistors (R0, R1...R8, Rr), operated from a biasing voltage (Ur), with the tapping points thereof, each via a switching connection consisting of one individual switching transistor or a series arrangement of switching transistors, and in dependence upon a digital selecting signal (A...D), capable of being connected through to the voltage output (U) by means of a selection circuit, with said selection circuit, said resistors (R...) and said switching connections being materialized by employing transistors according to the insulated-gate field-effect transistor technique, characterized by the combination of the following features:

– each switching connection is realized in the form of a CMOS transmission gate (G1...G8),

– the selection circuit consists of a 1-ex-n-short-circuit decoder (KD) and of a 1-ex-n-open circuit decoder (SD) whose like inputs are arranged in parallel and supplied with the corresponding bits (A...D) of the selecting signal,

– the open-circuit decoder (SD) consists only of transistors of the one channel conductivity type which are arranged in the semiconductor body of the integrated voltage divider as connected to the reference potential (UO) of the source of biasing voltage (Ur), and its potential input is connected to the reference potential (UO),

– the short-circuit decoder (KD) consists only of transistors of the other channel conductivity type (p-channel in the drawings), which are arranged within a separate insulating island (NW) of the one channel conductivity type, and its potential input is connected to this insulating island (NW) and to the operating voltage (Ud), and

– the one control inputs of the CMOS transmission gates (G1...G8) are connected directly to the like outputs (1,..8) of both the open-circuit and the short-circuit decoders (SD, KD), and the other control inputs thereof are each connected via a CMOS inverter (I1...I8) to the like outputs (1...8) (Fig. 5).

3. A voltage divider as claimed in claim 1 or 2, characterized in that said open-circuit decoder (SD) is composed of n-channel transistors only, and that said short-circuit decoder (KD) is composed of p-channel transistors only.

4. A voltage divider as claimed in one of claims 1 to 3, characterized by the following features:

– the switching transistors which, with respect to the center tapping point, belong to negative partial voltages, are n-channel transistors (N1...N4), and the switching transistors which, with respect to the center tapping point, belong to positive partial voltages, are p-channel transistors (P5...P8), and

– the part of the open-circuit decoder associated with the positive partial voltages, is designed as an n-channel short-circuit partial decoder (NK), and the part of the short-circuit decoder associated with the positive partial voltages, is designed as a p-channel open-circuit partial decoder (PS) whose respective inputs, in an inverted order of succession, are connected to the corresponding inputs of either the remaining n-channel open-circuit partial decoder (NS) or the remaining p-channel short-circuit partial decoder (PK) (Fig. 6).

5. A voltage divider as claimed in one of claims 1 to 3, characterized by the following features:

– the switching transistors which, with respect to the center tapping point, belong to negative partial voltages, are n-channel transistors (N1...N4), and the switching transistors which, with respect to the center tapping point, belong to positive partial voltages, are p-channel transistors (P5...P8),

– the partial decoder of the open-circuit decoder, associated with the positive partial voltages, consists of p-channel transistors, and the partial decoder of the open-circuit decoder associated with the negative partial voltages, consists of n-channel transistors, and

– in the short-circuit decoder, the channel conductivity types of the partial decoders, with respect to the partial voltages, are associated exactly inverse to those in the open-circuit decoder.

6. The use of a voltage divider as claimed in any one of claims 1 to 5, with a digital-to-analog converter, i.e., in such a way that

– the selecting signal is a natural n-bit binary signal,

– the voltage divider has at least $N = 2^n$ equally dimensioned resistors, and

– the voltage output (U) is connected to the input of a voltage amplifier (SV), particularly one having a gain 1, whose output is provided with an RC smoothing circuit (GG).

FIG.1

0 065 022

1/6

## FIG.2

| | 0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| A | L | L | L | L | L | L | L | L | H | H | H | H | H | H | H | H |
| B | L | L | L | L | H | H | H | H | L | L | L | L | H | H | H | H |
| C | L | L | H | H | L | L | H | H | L | L | H | H | L | L | H | H |
| D | L | H | L | H | L | H | L | H | L | H | L | H | L | H | L | H |

## FIG.3

SD

IA TN IB IC ID

A B C D

UO

## FIG.4

TP

D C B A

ID IC IB IA

KD

WA

NW

Ud

11

FIG. 5

FIG. 6

FIG. 7

0 065 022

Ud

U

SV

+

−

RG

GG

CG

UA

UO

## FIG. 8

≡

GD

Ud

G..

UO

GN

## FIG. 9